(19) Europäisches Patentamt
European Patent Office
Office européen des brevets

(11) **EP 2 101 017 A2**

(12) **EUROPEAN PATENT APPLICATION**

(43) Date of publication:
**16.09.2009 Bulletin 2009/38**

(21) Application number: **08016704.2**

(22) Date of filing: **23.09.2008**

(51) Int Cl.:
*E04H 9/00* (2006.01)      *E04H 1/12* (2006.01)
*E04H 9/10* (2006.01)      *E04H 9/16* (2006.01)
*E04B 1/343* (2006.01)    *E04B 1/348* (2006.01)
*B65G 1/00* (2006.01)

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **11.03.2008 US 35516**

(71) Applicant: **Advanced Shielding Technologies
Europe S.L.
08940 Cornella de Llobregat (ES)**

(72) Inventor: **Daunert, Armillas Enrique
08173 Sant Cugat del Vallès (ES)**

(74) Representative: **Müller Fottner Steinecke
Rechtsanwälte Patentanwälte
Postfach 31 01 40
80102 München (DE)**

(54) **Portable modular data center**

(57)    Portable data center comprising one or more modular containers forming a modular containment structure which provide practical and efficient mobility as the data center can be quickly deployed at a remote site or location. Once deployed at a remote site or location, the portable data center can be started in a plug and play fashion, thereby minimizing the connection time to external utilities. The modular containment structure of the portable data center houses and maintains for operation various types of information technologies (IT) equipment, such as computer servers, Network Area Storage devices, data communication routers and switches and also the support equipment to make them operational such as electrical switchboards, high precision air conditioning and an uninterruptible power supply. The containment structure of the portable data center offers a secured and stable environment, which includes minimizing any external temperature transmission into the containment structure, regardless of the external environmental conditions.

EP 2 101 017 A2

**Description**

CROSS-REFERENCE TO RELATED APPLICATION

This application claims the benefit of U.S. Provisional Application Serial No. 61/035,516 entitled PORTABLE MODULAR DATA CENTER and filed on March 11, 2008, the entirety of which is incorporated herein by reference.

TECHNICAL FIELD

The invention relates generally to data centers and in particular to portable data centers that are mobile, modular, secure and fully operational at a desired location.

SUMMARY

The subject application provides a modular containment structure that satisfies a plurality of growing needs in the marketplace. As will be discussed in further detail below, the modular containment structure provides practical and efficient mobility as it can be quickly deployed. Once deployed at a remote site or location, the containment structure can be started or in a plug and play fashion, thereby minimizing the connection time to external utilities. The modular containment structure houses and maintains for operation various types of information technologies (IT) equipment, such as computer servers, Network Area Storage devices, data communication routers and switches and the support equipment to make them operational such as electrical switchboards, high precision air conditioning, and uninterruptible power supply are within the modular containment structure, the containment structure offers a secured and stable environment, which includes minimizing any external temperature transmission into the containment structure, regardless of the external environmental conditions (e.g., heat, cold, water, snow, etc).

Structurally, the modular containment structure comprises a standardized housing through its use of a standard ISO freight container. As a result, the modular containment structure is a totally stand-alone, self-sufficient unit and relies only on external power supply resources. In terms of security, the ISO container comprises a steel structure with an inner shell wherein the doors and cable glands are secured. Thus, a very high level of security is provided to protect the computer and related equipment in order to maintain a fully functioning remote data site.

The modular containment structure is also scalable and is designed to be configured as desired to satisfy the needs of the user. For example, power density can be modified as well as the number, type or organization of racks which hold the equipment. As interior space demands increase, the data center can be grown by attaching additional modules to each other. Portability of the growing containment structure does not become a concern either because the containment structures can be stacked on one top of the other. Internally, space can be optimized by rail guided racks, for example, which allow for more efficient and more flexible installation of most tower-type of IT equipment.

The modular containment structure also comprises an inner thermal insulation that provides a superior thermal efficiency with very low power loss ratios (in cooling) which make it suitable to operate in any extreme environments (desert, polar), with marginal internal cooling power losses. As a result, the structure is energy efficient. Furthermore, many of the materials used in the modular containment system are recyclable. In addition to be energy efficient and environmentally conscious, the modular containment system is resistant to fire for up to 120 minutes, has a water tightness up to IP X5 level and comes equipped with anti-vandalism doors up to level category 4.

BRIEF DESCRIPTION OF THE DRAWINGS

Fig. 1 illustrates a general diagram of a portable modular data center in connection with an aspect of the subject application.
Fig. 2 illustrates an exemplary cable gland as used in association with a portable modular data center in connection with an aspect of the subject application.
Fig. 3 illustrates an exemplary overpressure value as used in conjunction with a portable modular data center in connection with an aspect of the subject application.
Figs. 4A and 4B illustrate an interior view of a portable modular data center in which the side walls are either retracted (Fig. 4A) or extended (Fig. 4B) in accordance with an aspect of the subject application.
Figs. 5A and 5B illustrate a close-up view of an exemplary retracted side wall (Fig. 5A) and an exemplary extended side wall (Fig. 5B) in accordance with an aspect of the subject application.
Fig. 6 illustrates an expansion diagram of telescopic joint that is used in conjunction with retracting and extending the side walls of a portable modular data center in accordance with an aspect of the subject application.
Fig. 7 illustrates an exemplary telescopic joint that is used in conjunction with retracting and extending the side walls of a portable modular data center in accordance with an aspect of the subject application.

Figs. 8A and 8B illustrate an exemplary rack sliding rail system used in conjunction with racks installed in a portable modular data center in connection with an aspect of the subject application.

Figs. 9A, 9B, and 9C illustrate an exemplary rail of a rail guiding system used in conjunction with a portable modular data center in connection with an aspect of the subject application.

Fig. 10 illustrates exemplary flexible cable chains used in conjunction with a portable modular data center in connection with an aspect of the subject application.

Fig. 11 illustrates a schematic representation of a high power density 40 foot container in connection with an aspect of the subject application.

Fig. 12 illustrates a schematic representation of a high power density 40 foot container in connection with an aspect of the subject application.

Fig. 13 illustrates a schematic representation of an in-row cooling unit used in conjunction with an installation of multiple racks in a portable modular data center.

Figs. 14 and 15 each illustrate an exemplary configuration for a 20 foot portable modular data center.

Figs. 16 and 17 each illustrate an exemplary configuration for 2 - 20 foot portable modular data centers.

Figs. 18 and 19 each illustrate an exemplary horizontal configuration for the interior of more than two 20 foot portable modular data centers that are assembled to create a larger data center.

Fig. 20 illustrates an exemplary configuration for the interior of a 40 foot portable modular data center.

Fig. 21 illustrates an exemplary horizontal configuration for the interior of two 40 foot portable modular data centers In order to create a single larger data center.

Fig. 22 illustrates an exemplary configuration of multiple 20 and/or 40 foot portable modular data centers in order to create an interconnected portable modular data center park or complex.

Fig. 23 illustrates an exemplary vertical configuration of multiple portable modular data centers.

DETAILED DESCRIPTION

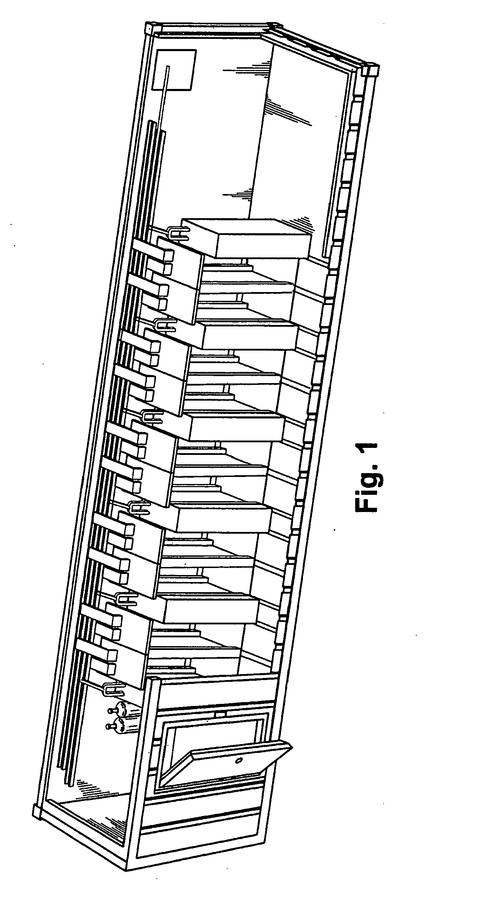

As demonstrated in Fig. 1, the portable data center or PMDC comprises the following components: a modular container (e.g., ISO steel container), an inner modular room (e.g., Smart Shelter - IT modular security room), and specific installations and accessories. The ISO Container comprises a standardized outer steel shell that houses the PMDC. The Smart Shelter - IT Modular Security room comprises a modular room made by a modular panelling system that is wrapped inside the ISO container and provides an adequate environment suitable for IT equipment. According to an aspect of the subject application, the Smart Shelter can be considered to be the core of the PMDC. Specific installations and accessories comprise all installations (e.g., power, cooling...) fitted inside or outside the PMDC to make it operational and suitable for IT equipment.

In particular, the ISO container is a steel shell cube made of a steel sheet structure (e.g., walls, base, and ceiling) that provides the adequate enclosure for the Smart Shelter modular IT room. The containers that can be used are the standard ISO High Cube measuring at 20 feet long and the standard ISO High Cube measuring at 40 feet long, which provide the benefits as described above. Additional benefits include but are not limited to data center portability, reduced footprint, protection against environmental risks that could affect a data center's normal function such as natural risks and human risks, and energy efficiency. Some examples of natural risks include flood or water damage, heat, fire, storms, earthquakes, wind damage, tornadoes, hurricanes, and the like. Examples of human risks include but are not limited to electromagnetic fields, vandalism, sabotage/terrorism, restricted access, and the like.

The overall structure of the ISO container can be divided into its base structure, door structure, core structure, side walls and ceiling. The base structure is made with longitudinal stringers of steel with a high elastic limit, joined via steel crossbar(s) in the shape of a "C". Regarding the door structure, the door is fitted within the internal structure of the ISO container although it can be accessible through an opening in the container wall structure. The outer door frame is made of posts of steel joined by continuous weld. The top frame is made of a top crossbar of steel of closed section, with sheets of protection and reinforcement before possible impacts produced by the devices that are handling it. There can also be a low crossbar on the door made of carbon-steel of opened section. The core structure comprises steel posts with open section, a top crossbar made of steel pipe with steel protection sheet and reinforcement to prevent possible damages produced by impacts, a bottom crossbar of steel with open section, and a front wall made of crimping steel sheet.

The sidewalls can be made of crimping steel sheets, joined by continuous weld; and the ceiling can be made of crimping steel sheet joined to the structure by continuous weld. In addition, there can be four anchoring points on the bottom as well as four on the top of the ISO container. For easy identification or other purposes, the ISO container can also be painted using an abrasive treatment to obtain level SA 2.5, whereby the outside can require a primer Epoxy 70uc, acrylic finishing 120uc, and logos painting, the interior can be coated with a primer Epoxy 90uc; and the base can use bituminous painting 180uc.

The various dimensions of the ISO container are provided in Table 1 below.

Table 1. ISO Container Dimensions

| Measurements / Type | ISO 20'HC | ISO 40'HC |
|---|---|---|
| **Gross weight** | 24000 kg | 30480 kg |
| **Payload** | 21750 kg | 26280 kg |
| **Tare** | 2250 kg | 4200 kg |
| **Volume** | 31.8 m$^3$ | 76 m$^3$ |
| **External Dimensions** | | |
| **Length** | 6.058 m | 12.192 m |
| **Width** | 2.438 m | 2.438 m |
| **Height** | 2.895 m | 2.895 m |
| **Internal Dimensions** | | |
| **Length** | 5.900 m | 12.010 m |
| **Width** | 2.330 m | 2.330 m |
| **Height** | 2.690 m | 2.690 m |
| **Door Opening** | | |
| **Width** | 2.330 m | 2.330 m |
| **Height** | 2.580 m | 2.580 |

The inner IT modular secure room structure (inner module) employed in the modular containment structure can be referred to as the Smart Shelter. The Smart Shelter is built within the given steel ISO Container and has a modular construction made of panels made to size to adequate the ISO container in such way that can accommodate IT equipment inside. This solution allows:

- Modularity: although the Smart Shelter creates a tight and enclosed room by itself inside the PMDC container, in a given moment, some panels could be removed and stack together several PMDCs, creating a single room space.

- Fast and clean construction: using modular panels allows a fast and clean construction process. Mechanical assembly clean and dust free

- Optimized adaptability to the Container's dimensions: minimum space lost between the Smart Shelter walls and ISO Container structure room walls.

- Construction with no intermediate room columns.

- Re-use of room panels: recyclable components.

- Laqued Smart Shelter walls surface finishing: keeps the inner rooms clean for IT equipment.

- High mechanical resistance of panels (2 sheets of steel and intermediate high density mineral fiber compound).

- Electro-Magnetic Shielding.

- Joints between panels are dovetailed and sealed with protective silicone and special profiles to allow a high level protection against intrusion.

For special cases or applications where extra thermal insulation may be required, panels of 120MM thickness can be used. The inner module comprises wall and ceiling panels which provide the adequate insulation and protection to install IT equipment inside of the modular containment structure. The inner walls and ceiling are designed with a single panel wall structure of 80 mm thickness, with two layers of laqued galvanized steel (total 1 mm steel) which provide stiffness. The inner laqued white color gives a smooth finish to the panels and mitigates the need for paint or other special finishing treatment. The finish also maintains a clean surface for the walls which is preferred if not required for certain types of environments such as IT equipment or clean room environments.

Within the inner module, all structure joints are dovetailed and can be sealed with silicone for perfect sealing. Each panel is also dovetailed to one another to guarantee perfect fitting with the other, avoiding humidity leaks and ensuring perfect fitting when either mounted horizontally or vertically. Panels are 100% reusable and can be easily relocated into new sites in a matter of hours, thus making the modular containment structure investment a long-term value asset, rather than a one-time work.

Horizontally compacted and stratified isolation fibers meshed with additional components, within the panel interior provide a perfect shield against air conditioning, heat, water and any other leaks. Heat isolation is twice better than traditional gypsum walls. Metal profiles attached to the inner side of the ISO Container steel walls and to the outer face of the wall panels fix and support the whole inner structure of the inner module panels. The fixing metal profiles have either a U or L shape, depending on where the panels have to be installed (e.g., walls, ceiling, or floor). Profiles are made of 1 MM thickness galvanized steel or anodized aluminum. Profiles are securely fastened to the site's floor. Panels are screwed together into the profiles, so the structure remains very stiff. The metal profiles of U and L shape have an extra side height to ensure water tightness. Joints are sealed perfectly in order to accomplish prior specifications. Also, any expansion jobs are clean, fast, and dust-free. Specially trained assembly engineers provide a perfect mechanical assembly (no traditional construction process).

The flooring system of the inner module comprises a floor panel made also of a special modular panel, easy and fast installation. The floor panel should be able to adapt to small differences in floor levels existent in a concrete slab. In addition, the floor is made out of high density materials (up to 175 kg/m2) in order to provide fire protection, thermal stability, and acoustic isolation among others. In particular, the top layer of flooring panel can be made of at least a 1 mm thickness galvanized steel plate. This flooring should be able to support a raised floor system plus a weight from racks and machines up to 2000 kg/m2. Overall, the floor panel can have a total thickness of about 60MM. However, it should be appreciated that the total thickness can vary higher or lower than 60MM depending on the user's needs.

The inner module comprises a secured door which is isolated in order to provide a high level of thermal insulation, protection against fire and water. For example, the door can have a door sheet thickness of 120 mm and a double edge frame as well as a height of about 2.0 meters. There may be one or two (one or more) sheet doors employed, and the door can be equipped with a security lock that may also be fire resistant. In the event of an emergency, exit from the inside of the inner module can be made with an anti-panic bar. Additionally, the door can have an automatic mechanical closing system integrated (no motor provided) and/or an electronic system integrated for access system installation that is optionally adapted with an automatic motor for opening and closing such door(s). The door can also be manufactured with a steel plate frame of about 2.5 mm on each side, for example.

The door as well as the complete modular secure room accomplishes physical stability and thermal stability in case of external fire. For instance, the average temperature inside the room should remain under 75 ˚C during 60 minutes of fire exposure and under the same maximum levels as requested by European standards (e.g., EN-1047-2 standard). The door should also provide vast protection of water resistance at IP x5 level (water hose propulsion to structure room) such as, for example, according to a different European standard (e.g., EN 60529 Standard).

The door can also be designed according to level 4 of EN1627 standard when used in Europe, which implies high protection against intrusion. All installed materials shall be non-combustible according to levels established by ISO 1182 standard. The door, jointly with the structure enclosure, shall provide a minimum protection of 20dB against external or environmental electromagnetic fields according to European standard EN 61000-4-3 and a minimum acoustic isolation of 31dB inside a range between 100 Hz and 4 kHz. With respect to gas emanation and thermal isolation, under test conditions according to fire curves of EN-1047 standard, the door and whole room shall remain water tight for 60 minutes and no gas inside shall be detected. Regarding mechanical stability, door jointly with the room shall be in optimal conditions of mechanical stability for at least 60 minutes of exposure which is required under test conditions according to fire curves of the EN-1047 standard. In addition, the door and room shall be designed according to TIA-942 standard.

The interior Smart Shelter room or structure (within the portable data center) provided herein fulfills the following specifications and standards:

- The complete room structure (of the Smart Shelter which is made of wall panels, ceiling panels, floor panels, door, cable glands, corners and joints) must accomplish physical stability and thermal stability in case of external fire. Average temperature inside the room should remain under 75 ˚C during the first 60 minutes of fire exposure and under the same maximum levels requested by the EN-1047-2 standard.

- The structure must keep levels of relative humidity under 95% in case of external fire according to test perform in accordance to EN-1047-2 standard.

- The room shall be able to be constructed with the same dimensions showed in the drawings in order to avoid space being lost in the perimeter of the room. In other words, the room structure should be able to be mounted with a maximum distance of 50 mm from the existing walls of the room.

- The room structure should provide a vast protection of water resistance at IP x5 level (water hose propulsion to structure room) according to EN 60529 Standard.
- The walls and ceiling should be specially design and certified as fire resistant 120 minutes division elements according to UNE-23802.
- The maximum thickness for walls and ceiling panels should not exceed 82 mm, with a maximum weight of 25 kg/m2, in order to comply with design room dimensions and weight calculations.
- All materials installed should comply with non-combustibility classification levels in accordance with standard ISO 1182.
- The structural room shall provide a level of protection of at least 20 dB from external sources of electro-magnetic disturbance according to EN 61000-4-3.
- With the structure solution shall be provided a basement made of non-combustible materials in accordance to ISO 1182, with a maximum panel thickness of 62 mm, being able to withstand at least 2.500 kg/m2. The goal of the basement is to provide an isolation layer from the concrete ground with fire protection of approximately 90 minutes protection as a self tested.
- Acoustic Isolation shall be provided with a mean value of 31 dB in a range of frequencies from 100 Hz to 4 kHz.
- Thermal isolation should be of at least 0.42 W/m2 K in order to isolate the room to provide advantages as per energy savings, etc.
- All structural room design shall be constructed and design according to TIA-942.

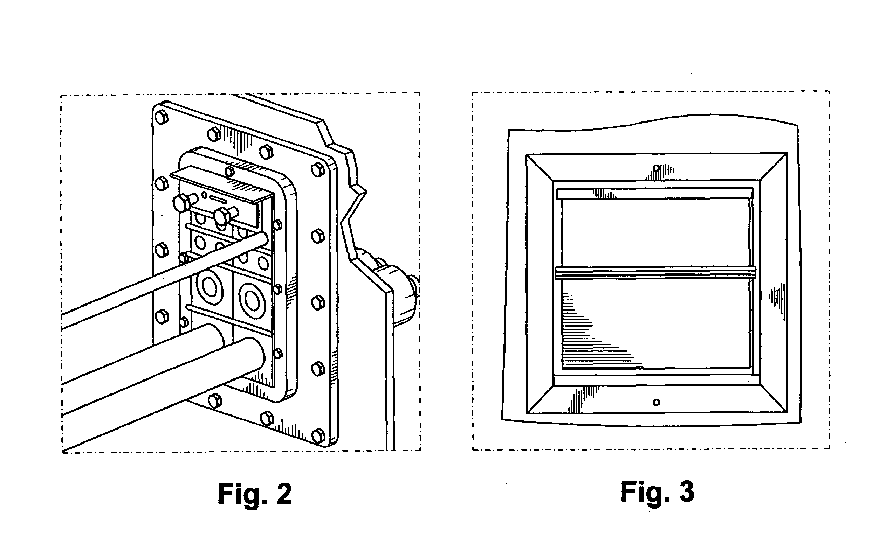

The Smart Shelter room structure can also include various accessory systems to further facilitate protection against the elements (e.g., water, heat, cold, etc.), fire and intruders. For instance, the room structure can include some insulating systems for cable and pipe entry - referred to as a cable gland as represented in Fig. 2 - which are fire and water resistant. The type used provides a sealed cable entrance. This system is made by modules with practicable diameters depending on cable diameters, with steel frames. The cable gland is fitted inside the ISO Container wall and also inside the structure of the Smart Shelter wall using an inside frame and an outside frame, both made of galvanized steel. Complete sealing can be made by adaptable modules and a compression unit.

Mandatory standards and conditions for cable glands can be:

○ Cable gland, jointly with complete structure (composed by walls, corners, joints, doors and cable glands) shall provide thermal stability in case of external fire. It must remain under average levels of temperature and humidity established for case of fire according to EN1047-2 standard (standard of protection against fire for high security rooms) during 60 minutes (maximum temperature 70˚C and relative humidity of 85%).

○ Cable gland jointly with structure enclosure shall provide a minimum protection of 20dB against external or environmental electromagnetic fields according to European standard EN 61000-4-3.

○ Cable gland jointly with structure enclosure shall provide a minimum isolation of 31dB inside a range between 100 Hz and 4 kHz.

○ Gas emanation and thermal isolation: under test conditions according to fire curves of EN-1047 standard, door and whole room shall remain water tightness for 60 minutes and no gas inside shall be detected.

○ Mechanical stability: door jointly with room shall be in optimal conditions of mechanical stability during 60 minutes required under test conditions according to fire curves of the EN-1047 standard.

○ Cable glands shall provide high protection to the room against water according to IP67 level of European standard EN 60529.

○ All installed materials shall be non-combustible according to levels established by ISO 1182 standard.

○ Cable gland and room can be designed according to TIA-942 standard.

Referring now to Fig. 3, there is illustrated an exemplary overpressure valve, which can also be included in the Smart Shelter room structure. The overpressure value is used to reduce any overpressure inside room because of air renovation system, activation of gas fire extinguishing or access doors opening/closing. The system is composed by overpressure damper and slats with automatic opening depending on pressure inside room. This system protects against structural damage in walls, ceiling, doors, etc. in case of sudden or intense overpressure. Mandatory standards and conditions for overpressure valve include but are not limited to:

○ Fire dampers in accordance with DIN-4102 standard, fire resistant for about 90 minutes.

○ All installed materials are non-combustible according to levels established by ISO 1182 standard

○ All fire dampers are designed according to TIA 942 standard.

In order to protect against fire, a fire grill can be installed on the overpressure valve air intake. This grill is melted in case of contact fire forming an F90 (90 MINUTES RESISTANCE) screen that avoids external fire entries inside a computer room. Mandatory standards and conditions for the fire grill include but are not limited to:

○ Fire dampers are according to DIN-4102 standard, with fire resistance of about 90 minutes.
○ All installed materials are non-combustible according to levels established by ISO 1182 standard.
○ All fire dampers are designed according to TIA 942 standard.

To provide water tightness of the Smart Shelter room structure, a water tightness kit composed of black foam-rubber, with a self-stick side of 15mm x 7mm (width x height), can be applied to different parts of the Smart Shelter room such as the doors, panels and lids. It should be appreciated that the measurements of the black foam rubber can vary depending on the structures for which water tightness protection is desired.

In addition to protection from water and fire, the Smart Shelter room within the portable data center can also be constructed to protect against intrusions. Intrusion testing can include applying certain forces, in this case grade 4, for example, in the direction of the data center's door opening in different points.

The forces that are applied are as follows:

■ F3 = 10.000 N in the closing points
■ F2 = 6.000 N between the closing points
■ Preload= 300 N, both F2 and F3.

The test is considered successful if:

■ The deformation is less than 10 for F2
■ The deformation is less than 10 for F3.

As mentioned earlier, one of the advantages and/or benefits of the portable data center, as described herein, is its very high level of thermal efficiency. The thermal efficiency is based on the following thermal efficiency study. This thermal efficiency, allows the appropriate selection of air condition machines to be installed in the portable data center. A study was performed on two models of portable data centers, each housed within steel containers sized:
20' High Cube Container
40' High Cube Container.

The dimensions of these containers have been described before.

Thermal transference

Conductivities

K panel= 0.42 W/(m²xK)

λ air= 0.02 W/(mxK)

λ steel= 47-58 W/(mxK)

λ insulator= 0,03 – 0.07 W/(mxK)

λ thermal stabilizer= 0,029 – 0.036 W/(mxK)

$$q_x = -\lambda * \frac{dT}{dx}; \quad q_x = q_x'' * A$$

$$q_x = -\lambda * \frac{\Delta T}{\Delta x}; \quad \Delta T = q_x'' * \frac{\Delta x}{\lambda}$$

This can be represented as an electric circuit where $\Delta T$ is a voltage drop, $\Delta x/\lambda$ the resistance and $q_x''$ the current. The temperature inside the computer room, for example, should be $T_{int}$ =21˚C, and several estimations can be done for $T_{ext}$ according to the outside range temperatures. The data center will be subjected to extreme conditions of temperature in order to carry out a more realistic and exhaustive study.

We have different values of $\Delta T$ from the variation of external temperature, that with the resistance ($\Delta x/\lambda$), which will confirm allowance of the heat flow, and we should considerer it the study of climate.

Once the heat flows penetrate at the external surface, it will propagate by conduction. The conductivities are not variables. So the conductivities can always be considered constant and always in the most unfavourable case. In convection, the constant of the heat flow depends on the temperature of the environment so it should be considered.

$$R_{conv} = \frac{1}{h * A} = \frac{T_x - T_\infty}{q}$$

The thickness of steel sheet can be 1.5 mm and the quality of the steel will be St 37-2.

In the present study, a shelter is used with thermal isolation, and in a second case a shelter is used with thermal isolation and thermal stabilizer.

Table 2.

|  | Thermal insulator | Thermal stabilizer |  |
|---|---|---|---|
| e (thickness) | 0.081 | 0.041 |  |
| k (W / m² * K) | 0.42 | 0.9 |  |
| 1/k | 2.38 | 1.11 |  |
| (1/k) | 3.49 | | |
| $K_{total\ SS+}$ | 0.29 | | SS+ Panel |

As described before, the Smart Shelter room structure provides inner thermal insulation and an enhanced Smart Shelter room structure can provide additional thermal insulation levels for special cases.

We have to calculate $K_{total}$ (W / m$^2$ * K) for a 20' container, in which we are going to carry out two test, first only shelter with thermal isolation, and second with thermal isolation and thermal stabilizer.

**Smart Shelter Room Structure:**

$$\Delta T = T_{ext} - T_{int} = 65°C - 21°C = 44°C.$$

Table 3.

| CEILING | Air | Steel | Air | Air (cond.) | Air | SS Panel | Air |
|---|---|---|---|---|---|---|---|
| Length (m) | 5.655 | | | | | | |
| Width (m) | 2.150 | | | | | | |
| A (m$^2$) | 12.158 | | | | | | |
| e (m) | - | 0.0015 | | 0.068 | | 0.082 | |
| λ (W / m* K) | | 58 | | 0.02 | | 0.0336 | |
| k (W / m$^2$ * K) | | 38,666.67 | | 0.29 | | 0.41 | |
| h (W / m$^2$ *K) | 100 | - | 50 | - | 50 | - | 30 |
| R (m$^2$ * K / W) | 0.01000 | 0.00003 | 0.02000 | 3.40000 | 0.02000 | 2.44048 | 0.03333 |
| R$_{total}$ (m$^2$ * K W) | 5.924 | | | | | | |
| K$_{total}$ (W / m$^2$ * K) | 0.169 | | | | | | |

Table 4.

| FLOOR | Air | Steel | Air | Air (cond.) | Steel | Air | SS Panel | Air |
|---|---|---|---|---|---|---|---|---|
| Length (m) | 5.655 | | | | | | | |
| Width (m) | 2.150 | | | | | | | |
| A (m$^2$) | 12.158 | | | | | | | |
| e (m) | - | 0.0015 | | 0.17 | 0.04 | | 0.061 | |
| λ (W / m * K) | | 58 | | 0.02 | 58 | | 0.0336 | |
| k (W / m$^2$ * K) | | 38,666.67 | | 0.12 | 1.450.00 | | 0.55 | |
| h (W / m$^2$ * K) | 100 | - | 50 | - | 50 | 30 | - | 30 |
| R (m$^2$ * K/ W) | 0.01000 | 0.00003 | 0.02000 | 8.50000 | 0.02000 | 0.03333 | 1.81548 | 0.03333 |
| R$_{total}$ (m$^2$ * K / W) | 10.432 | | | | | | | |
| K$_{total}$ (W / m$^2$ * K) | 0.096 | | | | | | | |

Table 5

| LONGITUDINAL WALL | Air | Steel | Air | Air (cond.) | Air | Steel | Air | Air (cond.) | Air | SS Panel | Air |
|---|---|---|---|---|---|---|---|---|---|---|---|
| Length (m) | | | | | | **5.655** | | | | | |
| Width (m) | | | | | | **2.220** | | | | | |
| A ($m^2$) | | | | | | **12.554** | | | | | |
| e (m) | - | 0.0015 | | 0.0175 | | 0.0015 | | 0.008 | | 0.082 | |
| $\lambda$ (W / m * K) | | 58 | | 0.02 | | 0.0336 | | 0.02 | | 0.036 | |
| k (W / $m^2$ * K) | | 38.666,67 | | 1.14 | | 22.40 | | 2.50 | | 0.44 | |
| h (W / $m^2$ * K) | 100 | - | 50 | - | 50 | - | 30 | - | 30 | | 20 |
| R ($m^2$ * K / W) | 0.010 | 0.000 | 0.020 | 0.875 | 0.020 | 0.045 | 0.033 | 0.400 | 0.033 | 2.278 | 0.050 |
| $R_{total}$ ($m^2$ * K / W) | | | | | | 3.764 | | | | | |
| $K_{total}$ (W / $m^2$ * K) | | | | | | 0.266 | | | | | |

Table 6

| TRANSVERSE WALL | Air | Steal | Air | Air (cond.) | Air | Steel | Air | Air (cond.) | Air | SS Panel | Air |
|---|---|---|---|---|---|---|---|---|---|---|---|
| Length (m) | 2150 | | | | | | | | | | |
| Width (m) | 2.220 | | | | | | | | | | |
| A (m$^2$) | 4.773 | | | | | | | | | | |
| e (m) | | 0.0015 | | 0.0425 | | 0.0015 | | 0.0405 | | 0.082 | |
| $\lambda$ (W / m* K) | | 58 | | 0.02 | | 0.0336 | | 0.02 | | 0.036 | |
| k (W / m$^2$ * K) | | 38,666.67 | | 0.47 | | 22.40 | | 0.49 | | 0.44 | |
| h (W / m$^2$ * K) | 100 | - | 50 | - | 50 | - | 30 | | 30 | | 20 |
| R (m$^2$ * K / W) | 0.010 | 0.000 | 0.020 | 2.125 | 0.020 | 0.045 | 0.033 | 2.025 | 0.033 | 2.278 | 0.050 |
| R$_{total}$ (m$^2$ * K / W) (m$^2$ * K / W) | 6.639 | | | | | | | | | | |
| K$_{total}$ (W / m$^2$ * K) | 0.151 | | | | | | | | | | |

Table 7.

|  | Ceiling | Floor | Long. Walls | Transv. Walls |
|---|---|---|---|---|
| Area (m$^2$) | 12.158 | 12.158 | 12.554 | 4.773 |
| Units | 1 | 1 | 2 | 2 |
| K (W / m$^2$ * K) | 0.169 | 0.096 | 0.266 | 0.151 |
| K$_{total}$ (W / m$^2$ * K) | *0.0374* | | | |

**Enhanced Smart Shelter Room Structure:**

Table 8.

| CEILING | Air | Steel | Air | Air (cond.) | Air | SS Panel | Air |
|---|---|---|---|---|---|---|---|
| **Length (m)** | 5.575 | | | | | | |
| **Width (m)** | 2.070 | | | | | | |
| **A (m$^2$)** | 11.540 | | | | | | |
| **e (m)** | - | 0.0015 | | 0.068 | | 0.122 | |
| **λ (W / m * K)** | | 58 | | 0.02 | | 0.0336 | |
| **k (W / m$^2$ * K)** | | 38,666.67 | | 0.29 | | 0.28 | |
| **h (W / m$^2$ * K)** | 100 | - | 50 | - | 50 | | 30 |
| **R (m$^2$ *K / W)** | 0.01000 | 0.00003 | 0.02000 | 3.40000 | 0.02000 | 3.63095 | 0.03333 |
| **R$_{total}$ (m$^2$ * K / W)** | 7.114 | | | | | | |
| **K$_{total}$ (W / m$^2$ * K)** | 0.141 | | | | | | |

Table 9.

| FLOOR | Air | Steel | Air | Air (cond.) | Steel | Air | SS Panel | Air |
|---|---|---|---|---|---|---|---|---|
| **Length (m)** | 5.575 | | | | | | | |
| **Width (m)** | 2.070 | | | | | | | |
| **A (m$^2$)** | 11.540 | | | | | | | |
| **e (m)** | - | 0.0015 | | 0.17 | 0.04 | | 0.061 | |
| **λ (W / m * K)** | | 58 | | 0.02 | 58 | | 0.0336 | |
| **k (W / m$^2$ * K)** | | 38,666.67 | | 0.12 | 1,450.00 | | 0.55 | |
| **h (W / m$^2$ * K)** | 100 | - | 50 | - | 50 | 30 | - | 30 |
| **R (m$^2$ * K / W)** | 0.01000 | 0.00003 | 0.02000 | 8.50000 | 0.02000 | 0.03333 | 1.81548 | 0.03333 |
| **R$_{total}$ (m$^2$ K W)** | 10.432 | | | | | | | |
| **K$_{tatal}$ (W / m$^2$ * K)** | 0.096 | | | | | | | |

Table 10.

| LONGITUDINAL WALL | Air | Steel | Air | Air (cond.) | Air | Steel | Air | Air (cond.) | Air | SS Panel | Air |
|---|---|---|---|---|---|---|---|---|---|---|---|
| Length (m) | | 5.575 | | | | | | | | | |
| Height (m) | | 2.170 | | | | | | | | | |
| A (m²) | | 12.098 | | | | | | | | | |
| e (m) | - | 0.0015 | | 0.0051 | | 0.0015 | | 0.008 | | 0.122 | |
| λ (W / m* K) | | 58 | | 0.02 | | 0.0336 | | 0.02 | | 0.036 | |
| k (W / m² * K) | | 38,666.67 | | 3.92 | | 22.40 | | 250 | | 0.30 | |
| h (W / m² * K) | 100 | - | 50 | - | 50 | - | 30 | - | 30 | | 20 |
| R (m² * K / W) | 0.010 | 0.000 | 0.020 | 0.255 | 0.020 | 0.045 | 0.033 | 0.400 | 0.033 | 3.389 | 0.050 |
| R$_{total}$ (m² * K / W) | | 4.255 | | | | | | | | | |
| K$_{total}$ (W / m² * K) | | 0.235 | | | | | | | | | |

Table 11.

| TRANSVERSE WALL | Air | Steel | Air | Air (cond.) | Air | Steel | Air | Air (cond.) | Air | SS Panel | Air |
|---|---|---|---|---|---|---|---|---|---|---|---|
| Width (m) | | 2.070 | | | | | | | | | |
| Height (m) | | 2.170 | | | | | | | | | |
| A (m$^2$) | | 4.492 | | | | | | | | | |
| e (m) | - | 0.0015 | | 0.0425 | | 0.0015 | | 0.0405 | | 0.122 | |
| $\lambda$ (W / m * K) | | 58 | | 0.02 | | 0.0336 | | 0.02 | | 0.036 | |
| k (W / m$^2$ * K) | | 38,666.67 | | 0.47 | | 22.40 | | 0.49 | | 0.30 | |
| h (W / m$^2$ * K) | 100 | - | 50 | - | 50 | - | 30 | - | 30 | | 20 |
| R (m$^2$* K / W) | 0.010 | 0.000 | 0.020 | 2.125 | 0.020 | 0.045 | 0.033 | 2.025 | 0.033 | 3.389 | 0.050 |
| R$_{total}$ (m$^2$ * K / W) | | 7.750 | | | | | | | | | |
| K$_{total}$ (W / m$^2$ * K) | | 0.129 | | | | | | | | | |

Table 12.

| K gral. | Ceiling | Floor | Long. Walls | Transv. Walls |
|---|---|---|---|---|
| Area (m$^2$) | 11.540 | 11.540 | 12.098 | 4.492 |
| Units | 1 | 1 | 2 | 2 |
| K (W / m$^2$ * K) | 0.141 | 0.096 | 0.235 | 0.129 |
| K$_{total}$ (W / m$^2$ * K) | *0.0338* | | | |

The obtained values of thermal insulation K$_{total}$ (W / m$^2$ * K) are very low parameters in both cases (Smart Shelter and enhanced Smart Shelter room structures), which indicate minimal energy losses through the room portable data center surface to the environment. Only less than 0.03% of a Watt will be lost per each m$^2$ of wall, ceiling, floor surface in the portable data center for each °K of temperature difference between the portable data center and the exterior. This is an ideal situation, as we can ensure that all cooling power generated stays within the portable data center and is not lost as heat transfer. By way of example, a standard concrete room has insulation levels between 5 to 10 times higher, which translates in much higher heat losses and less energy efficiency. This study has been done taking into consideration standard air pressure at sea level and not considering any direct solar radiation, in which case, the results would have been more favourable to the portable data center.

For those cases where a specific number of racks are allocated to reside within the portable data center, such racks would be located in the center of the container (portable data center) and supported on a special rail guided system described ahead, with no need for any structural modification of either the container (portable data center) or of the Smart Shelter. However, for those cases that the portable data center has to accommodate a larger number of racks, instead of positioning those in along the center of the portable data center, allowing a front and a rear corridor, these will be installed facing to each other, leaving a central corridor empty, for technical staff circulation, and two smaller rear corridors at the back side of each rack line. Racks still will sit on rails, allowing front and back access, but facing each other.

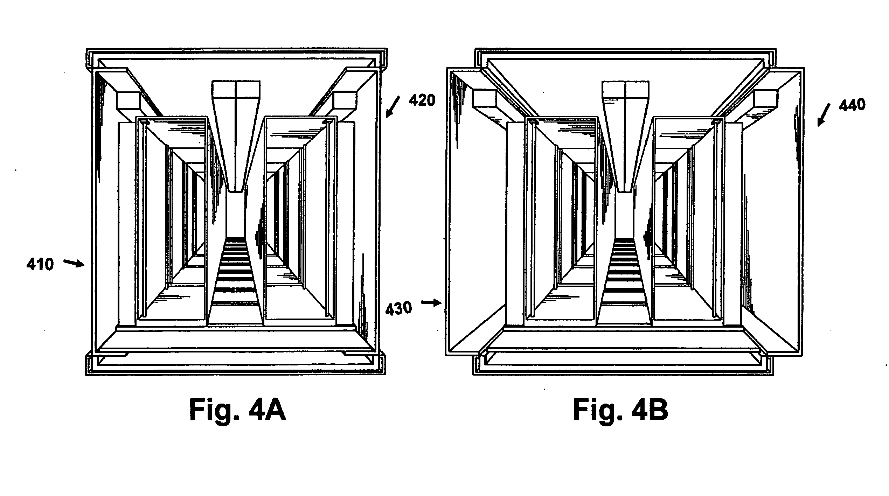

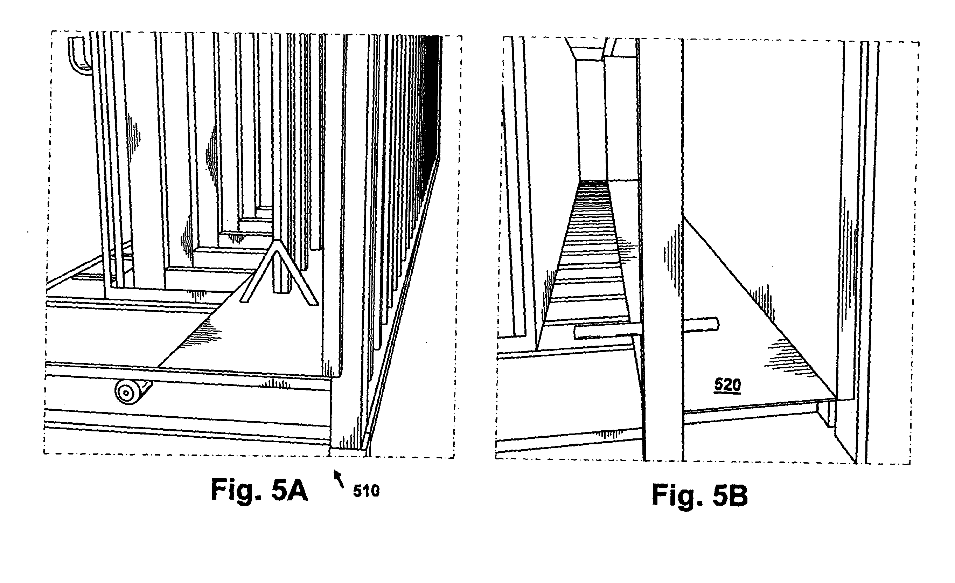

In order to increase the space between racks and create space in the central corridor, an aspect of the invention developed is an expandable/retractable system that allows the side walls to extend up to 1 meter per side, thus increasing the useful space inside and allowing more space for racks. Figs. 4A and 4B demonstrate different positions of the sidewalls. In particular, Fig. 4A illustrates an exemplary PMDC, wherein first and second sidewalls (410, 420) are in a retracted position. Fig. 4B illustrates the PMDC whereby the first and second sidewalls are in an expanded position (430, 440 respectively). Figs. 5A and 5B, respectively, depict a close-up view of the retracted (510) and expanded sidewall (520). Also by increasing the space on the rear corridor, the cooling of the racks is facilitated, as hot air is expelled on the rear side of the racks and we must allocate some space for hot air to circulate freely and not create heat bags that could overheat IT equipment. During transportation of the PMDC, the side walls can be retracted and all racks will be facing to each other at a minimum distance. Upon PMDC operation, once the side walls expand, the rail guided racks can be pushed out and the empty room left will become the central corridor.

The expandable/retractable system comprises an expandable/retractable side wall mechanism which is automated. The mechanism is composed of an electrical motor of 8 kW, and a rack and pinion system, allowing an outward displacement of the walls (e.g., up to 1000MM). The rack and pinion system comprises a steel rack which is positioned longitudinally along the door walls of the container, allowing the movement of the side walls, and so, extending the space inside the computer room, and creating a wide corridor between racks. The rack and pinion system comprises an electric motor with a speed reduction gearbox and a shaft, with a pinion at its end, provides a longitudinal movement into the rack, and hence opening of the side walls. The rack and pinion system can have two motors, one for each side wall. The shaft of the motor will have a pinion at its end, and that is what will be in contact with the steel rack and generate the movement of the side wall. Applying this mechanism, the space of the PMDC increases and more racks can be allocated within.

The expandable/retractable system also comprises expandable/retractable flooring and ceiling that are supported on rubber wheels and support extension bars. In particular, the extendable/ retractable flooring and ceiling system rolls on small rubber wheels, and side guides. The galvanized steel support extension bars help to sustain and push the floor and ceiling panels, forward and backwards. The support extension bars are distributed uniformly along the flooring and ceiling panel surface. These supports can bend up to 180° when fully extended.

One end of each support extension bar is bolted to the fix structure of the PMDC. The other end is screwed to the moving panel. When extended, the support extension bars, sustain the floor and ceiling panels and provide mechanical rigidity and load resistance. All moving panels' perimeter joints, have fire tight and water tight gaskets to maintain the fire and water tightness as established for Smart Shelter.

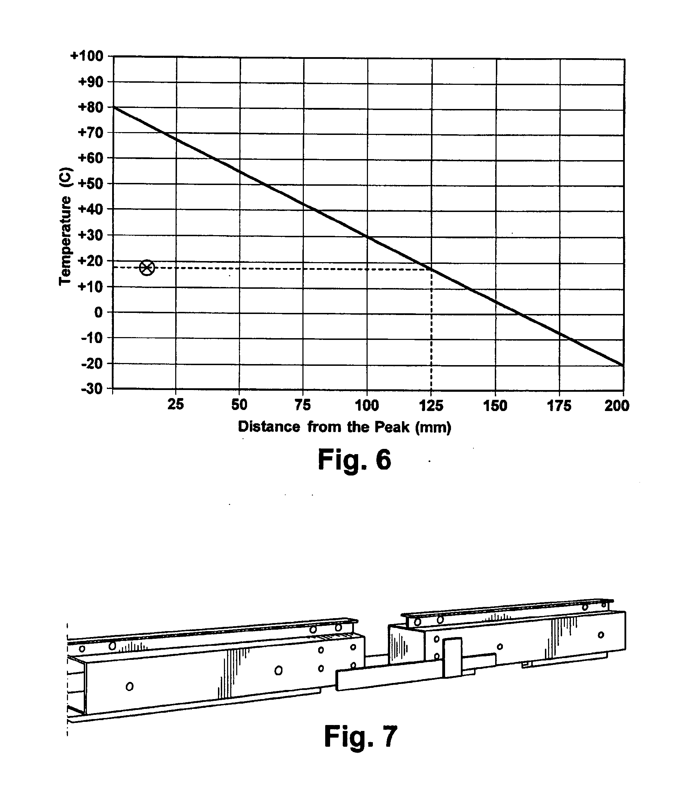

The moveable side walls must also provide fire and water protection. Despite the use of protection gaskets at the joints, an external telescopic joint as shown in Fig. 7 can be placed along the perimeter of the moveable part protecting the joint from direct exposure to the environment. The telescopic joint follows the movement of the side walls, ceiling and flooring. The joints are suited to any expansion conditions due to external conditions (heat, cold, ice...) as depicted graphically in Fig. 6.

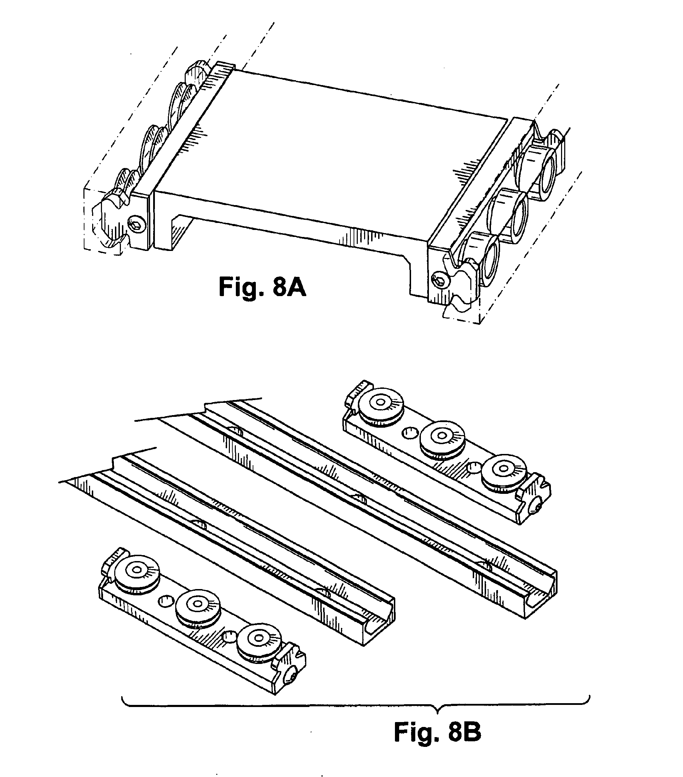

As mentioned earlier, racks are organized within the portable data center, or in particular within the inner room or Smart Shelter. Such racks are metal enclosures that can securely hold various types of IT equipment (e.g., computers, machines, servers, storage devices, etc). Due to the need to optimize space usage within the PMDC, and in order to facilitate access to operators to front and rear parts of the racks, the racks are mounted on a sliding rail guided system. The rails are made of light material, on which the ball bearing skates slide within. There are two rails per rack, and two skates per rail (total four skates). On top of the skates, there is a flat metal plate screwed in, on which we screw the racks' base. Thus, each rack is supported on four skates. Figs. 8A and 8B illustrate an exemplary rack sliding rail system.

This system is heavy duty, so it can manage loads > 500kg load per skate on the guiding plates with no problem. The racks will then glide on the flat plates, allowing easy access to the front and back of the rack. In such reduced space as the PMDC, this solution provides a significant advantage as it improves the working environment by providing good access for equipment installation (front) and access for maintenance purposes (rear).

As discussed, each rack is supported on two rails, and 4 skates slide within. Each skate has 3 wheels. The metal plate sits across the rails, bolted to each pair of skates, on top of which the rack is located. This system allows a longitudinal movement.

The travel speed of the base with a maximum load can be > 8 m/s, and the length of the tracks is as long as the width of the PMDC even with extended walls. Rails can be mounted on top of extended flooring system with some height supports to extend its travel. The rails have stoppers at its end in order to lock the position of racks and work as bumpers during movement of the racks.

This system has two free axes movement: the first and main one is longitudinal (X axis) and the second provides some radial axis movement (twist) from the front (Y axis), allowing some dampening for hard or sudden movements of the rack back and forward.

Table 13 represents a sheet of load values with a different number of wheels per skate:

Table 13.

| | Skate PW type | | Skate SW type | | | | | |
|---|---|---|---|---|---|---|---|---|
| | 3 - Wheel Only | | 3 - Wheel | | 4 - Wheel | | 5 - Wheel | |
| Size | Radial N | Axial N | Radial N | Axial N | Radial N | Axial N | Radia N | Axial N |
| 0 | 55 | 88 | - | - | - | - | - | - |
| 1 | 110 | 155 | 2300 | 1100 | 2300 | 1320 | 2760 | 1540 |
| 2 | 165 | 311 | 5300 | 1600 | 5300 | 1920 | 6360 | 2240 |
| 3 | - | - | 14000 | 6700 | 14000 | 8040 | 16800 | 11256 |

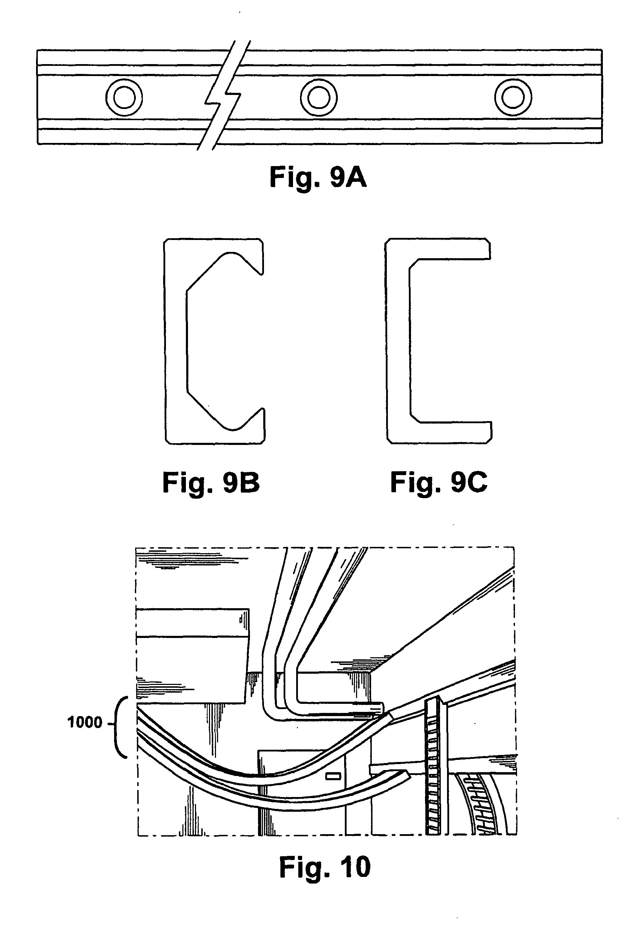

The number of wheels can be changed based on the type of load to install within the racks. The standard is 3 wheels per skate. Dimensions of the rail and skate guiding system of racks are illustrated in Table 14 and a guiding system rail is depicted in Figs. 9A, 9B (cross-sectional view), and 9C (cross-sectional view).

Table 14. Guiding System Rail Dimensions:

| Size | H | J | K | L max | M | N (dia x depth) | O | P |
|---|---|---|---|---|---|---|---|---|
| 1 | 15 | 4 | 26 | 3590 | 35 | 9.8 x 2,8 | 5.8 | 80 |
| 2 | 19.7 | 4.5 | 40 | 3590 | 35 | 14.3 x 3 | 8.8 | 80 |

Rails are fixed with long screws to the PMDC structural steel container floor, through the flooring panels, assuring its strong attachment.

Racks in the PMDC are located on top of the above mentioned sliding rail guided system, and they have a linear movement, back and forth when gently pushed. For the front and rear movement of cables (power cables and data cables), which are interconnected to the equipment inside the rack, a flexible, articulated, heavy duty plastic chain (Fig. 10 - indicated by 1000) for data and power cables is employed to avoid stressing those cables since such stress can eventually cause at least partial disconnection or damage to the cables. This flexible cable management system as illustrated in Fig. 10 (chains 1000) allows a smooth movement, expanding and retracting back and forth, protecting the cables which are passed through its interior, thereby mitigating damage or cuts to the cables due to movement.

The plastic cable chain used is made of articulated modular plastic pieces. The combination of these pieces, gives the whole system a smooth mobility, allowing that when racks slide on its rails, the cable can smoothly move together with the racks, without any stress or risk of disconnection. The flexible cable management system is fixed on one end to the rack, and on the other to the cable trays on the back wall of the Smart Shelter. There are at least two plastic chains per rack, one for power cables, and one for data cables.

It should be appreciated that one of the main design highlights of the PMDC, and of the various components described herein with respect to the PMDC, is that it integrates standardized components, avoiding the use of any special purposed design components. This is in order to make the PMDC more cost-effective, thereby facilitating servicing any part globally and simplifying sourcing.

As was discussed earlier, in order to comply with IT equipment environmental requirements, it is necessary to maintain a constant temperature inside the PMDC at 21° C with tolerance of +/- 1° C and relativity humidity of 50% with tolerance of +/- 5%. Cooling will be provided by a water-based cooling system, made of fan coil units within the PMDC (with redundancy N+1: this is with one unit of back up), installed at the ceiling of the Smart Shelter. The fan coils will be connected by a piping system to an external water chiller with double circuit for the heats exchange/cooling circuit. The whole cooling system will be electronic-controlled in order to accomplish manufacturers' temperature specifications. Each overhead fan coil within the container has 26kW of cooling power. The overhead fan coils cold air output openings will be facing the front corridor and the hot air collection openings the rear corridor, to ensure the adequate air circuit efficiency. Table 15 indicates some exemplary technical specifications of the fan coil:

Table 15.

| | | |
|---|---|---|
| **Power** | Cold (kW) | 24,9 |
| | Heat (kW) | 26,6 |
| **Fan** | Air flow (m3/h) | 3300 |
| | Available pressure (mm.c.a) | 8 |
| | Number | 1 |
| | Power (kW) | 0,6 |
| **Battery thermal exchange** | Water flow (l/h) | 4300 |
| | Hydraulic connections | ¾" |

To provide stable and clean power supply for IT equipment, standardized UPS (Uninterrupted Power System) will be installed within the PMDC. Depending on power needed, various models with following specs can be supplied, from various manufacturers.

For fire detection in the PMDC, an early detection system "Very Early Smoke Detection Analyzer" type, supplied from various manufacturers, is preferably used. This system is installed in the PMDC and analyzes smoke by a vacuum system through an inlet pipe distributed in the PMDC. The Central Alarm system processes the air samples and identifies any smoke particle.

Its main features are:

- Wide sensitivity range
- Laser based smoke detection
- 4 configurable alarm levels
- High efficiency aspirator
- Four inlet pipes
- Airflow supervisor per sampling pipe
- Dual stage air filter
- Easy to replace air filter
- 7 programmable relays
- Referencing
- Event log
- Modular design
- Recessed mounting option
- Listings/approvals: UL, ULC, FM, LPC, VdS, CCCf, ActivFire, AFNOR

In case of fire within the PMDC, there is a Fire Extinguishing System interconnected to the Fire Alarm Central / Smoke Detection System. The Fire Extinguishing is provided by an Inert Gas System. The system is made of:

- Steel-made bottle without welding and special thermal treatments of the material.
- Distribution nozzle.
- Gas capacity according with Rack Safe volume.
- According to 84/55/CEE Standard and NFPA.
  It should be appreciated that the gas released is not toxic for human beings.

The PMDC integrates sensors and electronic systems in order to monitor and control the environmental conditions and equipment within the PMDC. Any change of state or malfunction may generate alarms if required. Monitored parameters include but are not limited to:

- Electronic control for doors opening/closing.
- Access Control Biometric identification by fingerprint and/or proximity cards for doors opening.
- Security cameras inside room allowing remote supervision.

    ○ Video-cameras with TCP/IP interface.

- Electronic control for fire extinguishing system.
- Flooding detection system by using cable installed at all critical areas allowing detection of exact area of leak.
- Alarms generated by SNMP protocol for:

    ○ Adequate function of equipment inside PMDC: Air conditioning, Power generators, UPS, power switchboard.
    ○ Environmental parameters including but not limited to:

      ■ Exceeding of temperature or humidity levels, by a sensor inside room.
      ■ Fire detection.
      ■ Fire extinguishing system activation.
      ■ Humidity detection, liquid fleaks and flooding.

Although not described in detail, PMDC integrates the following parts, installations and systems:

- Lighting
- Emergency lighting
- Covers and water drainage systems for condensed water
- Anti-static linoleum floor cover.

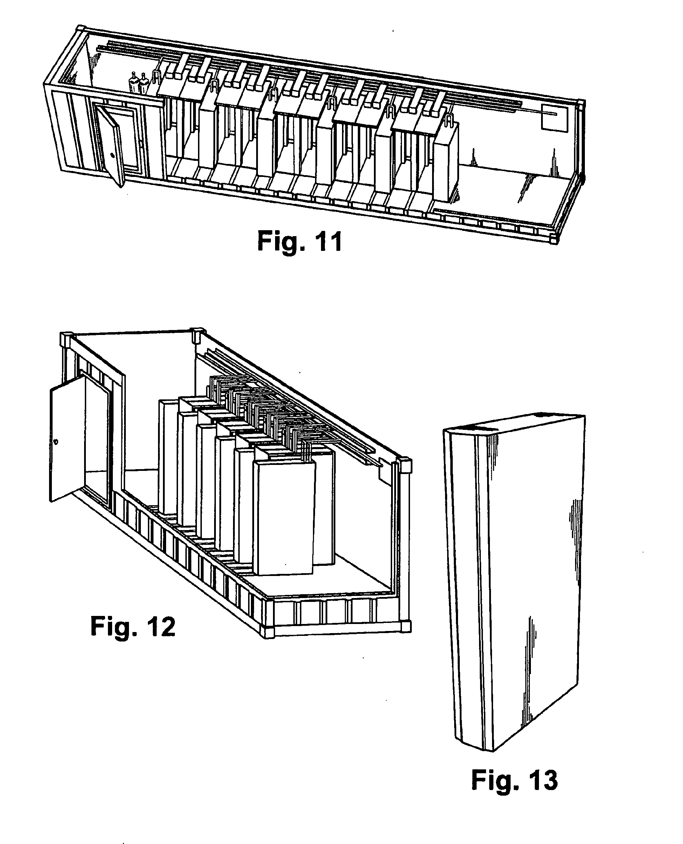

In terms of demanding commercial applications, PMDC can be adapted to match the high power and cooling requirements of new IT equipment technology. This technology integrates within a rack, multiple computers which require a large power (15kw to 30kw) per rack, and draw about 90% of such power as heat from the rear side of the rack. Overhead cooling fan coil systems will not provide enough cooling power; therefore, vertical-mounted cooling systems are installed between the racks. These cooling systems, sometimes called high density row coolers (e.g., in-row cooling unit in Fig. 13), are installed as shown in Figs. 11 - 12. These coolers could be gas or water cooler and are designed to provide high cooling power inside data centers.

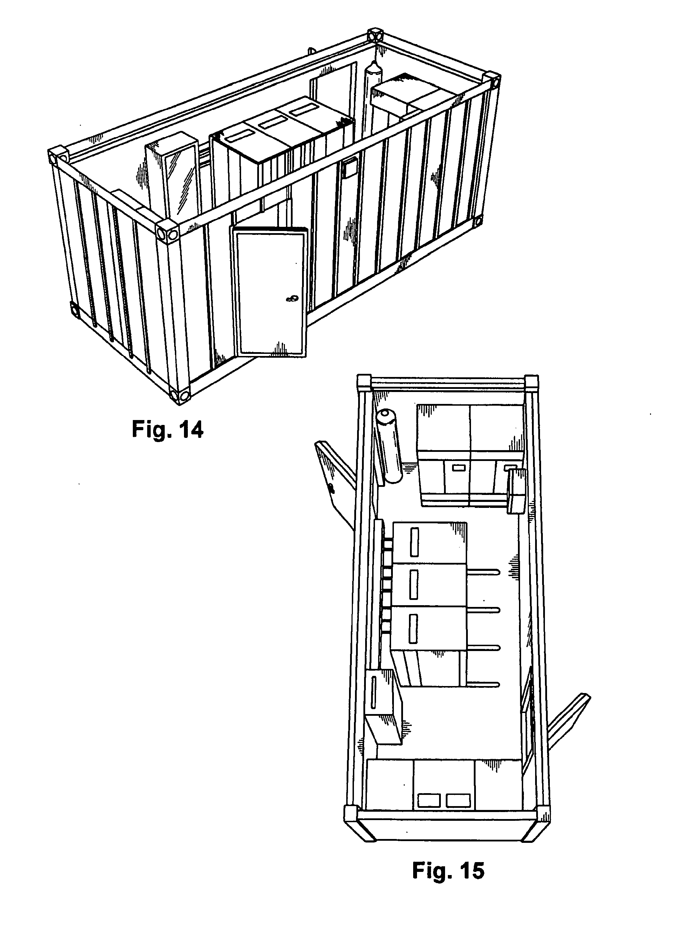

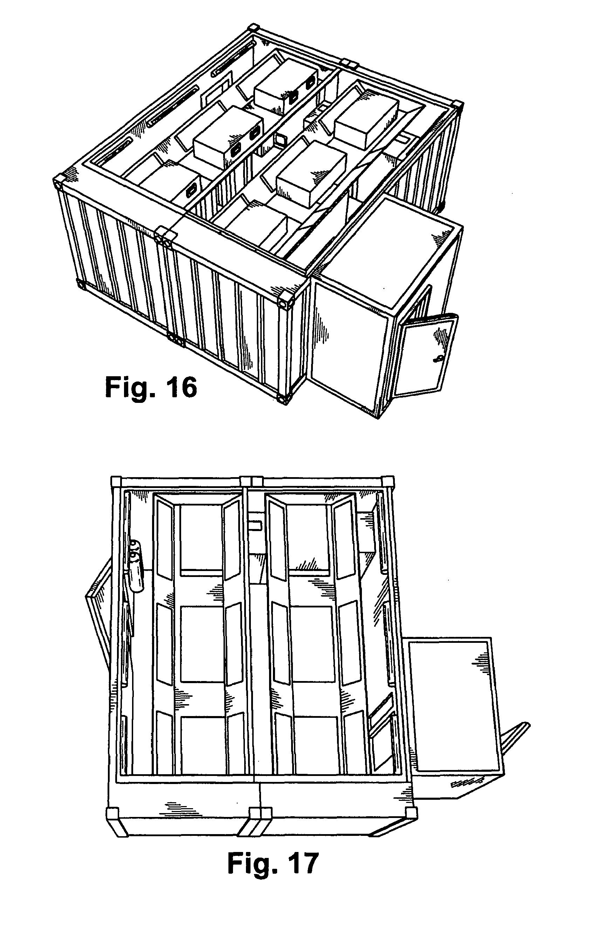

The PMDC can be configured in multiple ways to match the customer's needs and requirements. For example, for a 20' length PMDC (20' ISO container) including the aforementioned components described hereinabove, various configurations as pictured in Figs. 14 - 15 are possible. In addition, twin assembled PMDC 20' can be arranged in order to create a single diaphanous Data Centre space. The twin configuration as depicted in Figs. 16 - 17 includes all the benefits of 1x20' configuration, but there is no need for rack guide system installation because there are corridors between racks with enough width.

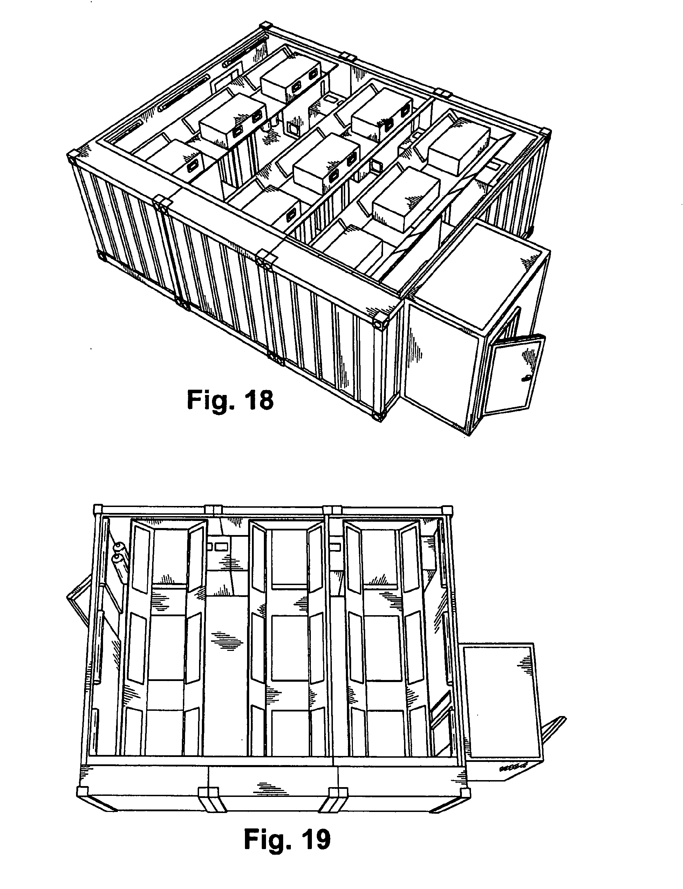

When more than two PMDC 20' are assembled in order to make a diaphanous Data Centre Room as demonstrated in Figs. 18 - 19, this configuration also includes all the benefits of the 1 x20' configuration as shown in Figs. 14 - 15 but there is no necessary rack guide system installed because there are corridors between the racks with enough width.

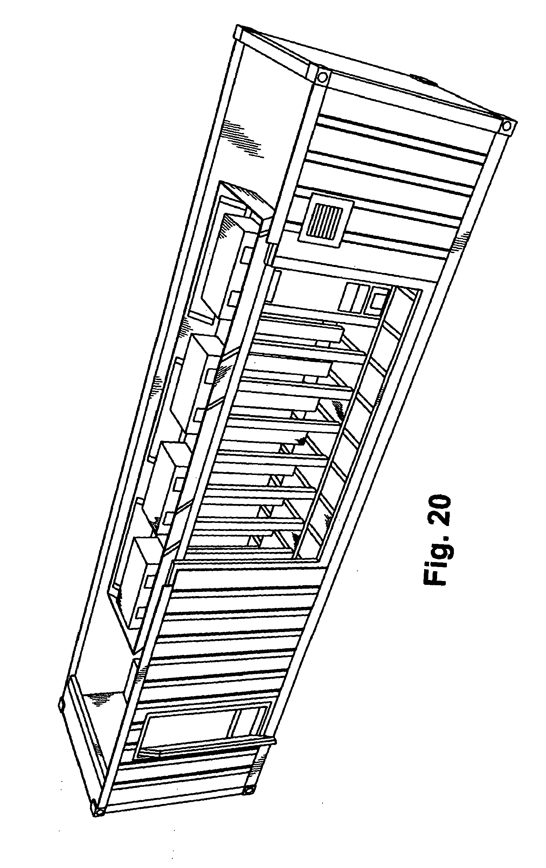

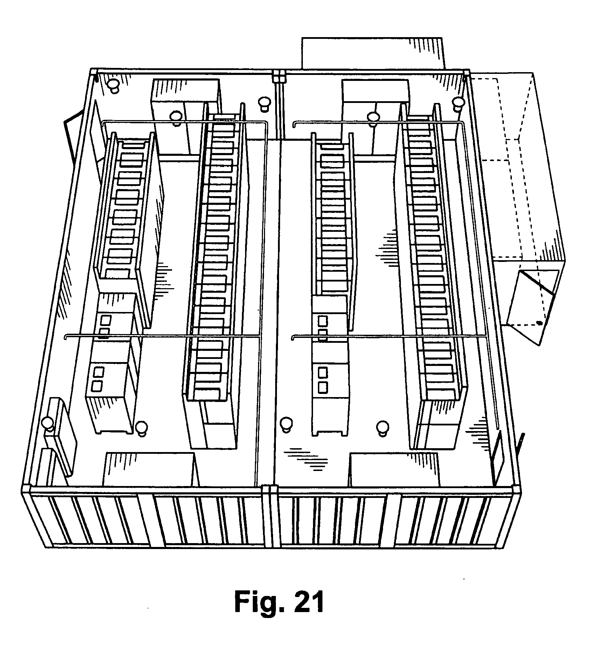

Fig. 20 illustrates the PMDC 40' configuration which includes all the various components described hereinabove. Fig. 21 depicts twin assembled PMDC 40' containers in order to make a single diaphanous Data Center space. The twin configuration includes all benefits of 1x40' configuration, but again, there is no need for a rack guided system installation because there are corridors between racks with enough width.

More than two assembled PMDC 40' units can be configured to create a single diaphanous Data Center space (not shown). As in the other 40' unit configurations, a configuration of more than two 40' units also includes all of the benefits of 1x40' configuration, but there is no need for rack guide system installation since there are corridors between racks with enough width.

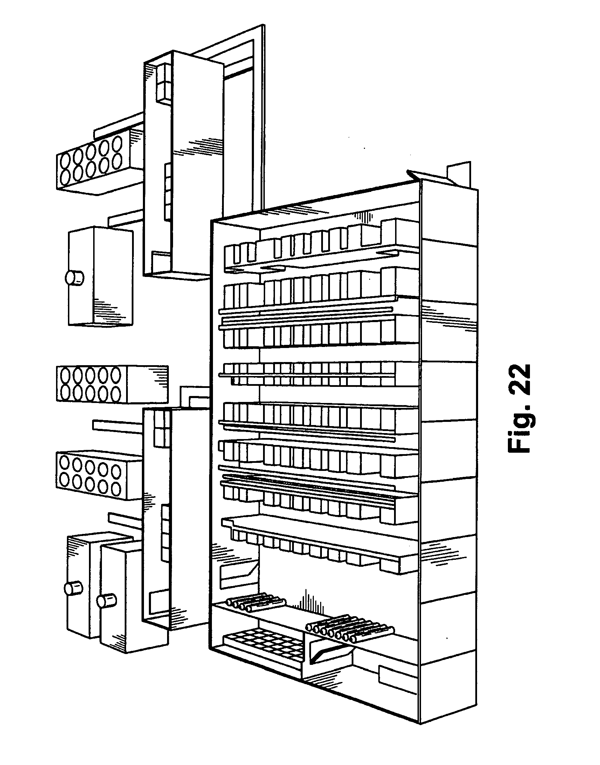

Referring to Fig. 22, it is also practicable to configure multiple PMDC 20' or PMDC 40' units to create a large Data Center area with all of the desired plant equipment services to support it (e.g., motor generator for emergency power supply, water chiller for cooling power supply and Main and secondary distribution switchboards).

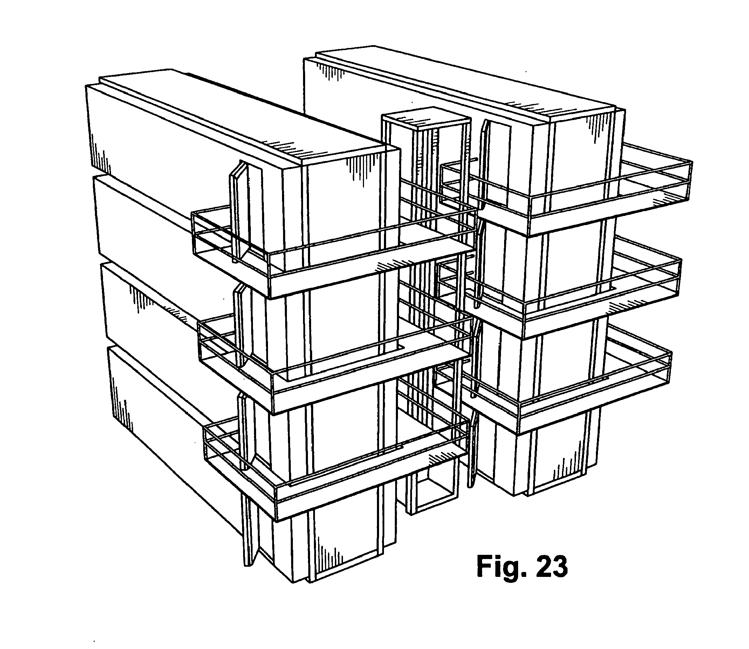

The PMDCs can also be vertically stacked as shown in Fig. 23. Vertical stacked configurations of nx20' or 40' PMDC can be done in order to make a high Data Center Room with all services including a motor generator for emergency power supply, water chiller for cooling power supply and main and secondary distribution switchboards. Such stacked configurations are also equipped with stairs and elevator with railing for easy and safe access.

The invention called Portable Modular Data Center (PMDC) described in this document provides the following innovations and benefits:

- **Portability and Rapid Deployment**. The Portable Modular Data Center (PMDC) is a self-standing, compact, fully integrated, plug & play Computer Data Center build within a standard ISO Freight CONTAINER of sizes 20HC and 40HC or other ISO Container sizes. PMDC is intended to be placed outdoors or indoors (warehouses). As PMDC's outside enclosure is an ISO Container, it can be transported by road, rail, ship and air, being able to transport it rapidly to any location world-wide. However, as it is designed with all plant equipment built-in (power, air conditioning,...) it is a stand-alone, self-sufficient, plug & play unit that can be deployed anywhere and immediately put into operation (the only external supply needed is a power utility feed).

- **Adequate Environmental protection for IT equipment.** IT equipment (computers,...) are delicate equipment that require very stable environmental conditions, a standard steel Container is not a suitable environment for these: the very high thermal transfer ratios of the ISO container thin (2MM) steel sheet walls and ceiling may results in severe internal temperature changes that even with powerful Air Conditioning systems, might not be possible to keep stable (Standards establish a constant 21˚C temp. requirement for IT equipment). Moreover, a standard ISO steel container also presents risks of possible water leakage into it, humidity, dust and smoke leak, non fire-resistance, burglary, etc... The innovation presented, is that, inside the ISO steel Container, and in order to provide the adequate environment for IT equipment, inside the ISO Container, it is built a modular secure room (Smart Shelter), made of modular, fire-resistant panels, with very high thermal insulation ratio, that completely wrap the ISO Container inside (walls, ceiling, floor) and that when assembled create a totally fire tight, water tight, smoke tight, Electro-Magnetic Interference shielded, burglary proof enclosure. Special equipment as cable glands, special door, overpressure valve, are included within the Smart Shelter inner room. Therefore within the ISO Container, it is created a totally isolated room, protected from any environmental influence and perfectly suitable for computers, regardless the final location of the ISO Container, even if the location is extreme (desert, polar, etc...).

- **Energy Efficient.** As per the high thermal insulation and tightness provided by Smart Shelter inner room, and the inner layout of the IT equipment inside (fitted in 19" , 42U Racks), creating separated input air cooled corridors and exhausted hot air corridors, the PMDC has practically no energy losses (low heat transfer) , optimizing the power consumption.

- **Environmental friendly**. All PMDC components are recyclable.

- **Re-configurable**. PMDC's inner physical layout can be reconfigured any moment to host different IT equipment of different type, or different Racks.

- **Scalability**. PMDC's power and cooling density can be retrofitted to scale up or down its power and cooling levels, at any moment.

- **Flexible design suitable to any IT equipment from any manufacturer**. As PMDC includes inside full Standardized 42U high (1U = 1,75") metal Racks for 19" IT equipment (to any depth), can host virtually any 19" IT equipment built to date from any manufacturer. Moreover, larger stand-alone computers, non-19", can also be fitted within.

- **Rack Sliding Rail Guide System**. 19˚ Racks can either: a) be aligned in the center of the PMDC, leaving a front corridor for access into the racks and a rear corridor for service; or b) racks can be placed in two rows along the long side walls, facing to each other with a central corridor between them for front rack access, and two rear corridors to access both lines of racks for service purposes. In any of both layouts, and to optimize space, all racks will be sitting on sliding guides. The sliding guide mechanism for each rack, consists of two parallel steel guides and four skates inserted within, on which the rack is bolted, so that when gently pushed back or forward, will have a travel back or forward up to approx. 500MM providing enough access for any service purpose. The system has stoppers to lock the racks at its standard position.

- **Flexible Cabling management system**. In order to avoid any cable stress when Racks may move back or forward, a flexible hard plastic chain will protect the power and data cables into each rack, moving along with it, when the rack may be displaced.

- **Expandable / Retractable walls and flooring and celing system**. To fit a high number of 42U 19" racks inside the PMDC, the racks are installed in two rows along the side walls. In order to have space for front and rear access into the racks, and despite racks have a movement due to the rail guided system, more physical space is needed. The PMDC includes an automated mechanism that will expand its side walls (up to 1000MM), and retract them creating extra space for access and to facilitate air convection.

- **Standardized support equipment**. All support equipment installed within PMDC (Air Conditioning, Electrical switchgear, Humidifiers, Fire Detection systems, Uninterruptible Power supplies, etc...) is totally standard, made by recognized manufacturers with global presence. This facilitates service and allows supplying PMDC versions suited to any country's standards and voltage requirements. Using standard equipment makes PMDC more cost-effective as well.

- **High Density Power and Cooling**. PMDC can be adapted for high density power needs, up to 30kW /Rack. Power supply can be designed to match such needs, and to provide cooling, vertical-mounted air conditioning units, attached to Racks, can be installed.

- **Multiple configurations**. Because of the universal compact shape of its external enclosure (ISO container), the PMDC can be stacked and joined in multiple ways. The PMDC can be supplied as a single stand-alone unit and grow into a complete large group of PMDCs, horizontally or/and vertically. It is possible also to configure the PMDC with removable partition walls and reproduce single larger areas, by attaching alongside two or more PMDCs.

**Claims**

1. A portable data center comprising:

   one or more modular containers, wherein the one or more modular containers comprise:

   > one or more expandable and retractable side walls;
   > expandable and retractable ceiling panels;
   > expandable and retractable floor panels; and
   > a plurality of racks comprising metal enclosures that are configured to securely hold equipment; and

   an inner modular room housed within the one or more modular containers, wherein the inner modular room comprises thermal insulation panels, one or more cable glands, at least one overpressure valve, a fire grill over air intake portion of the overpressure valve,

   > a) wherein the thermal insulation panels have joints that are dovetailed and sealed with protective silicone to mitigate leakage of heat, cold, water, and humidity; or
   > b) and an early detection fire system that analyzes smoke by a vacuum system through an inlet pipe distributed in the one or more modular containers, wherein the early detection fire system processes air samples and identifies any smoke particle.

2. The portable data center of claim 1, wherein the one or more expandable and retractable side walls expands and retracts in an automated manner.

3. The portable data center of claim 1, option a), wherein the one or more expandable and retractable side walls operates via a motor and rack and pinion system, wherein preferably the rack and pinion system comprises a steel rack positioned longitudinally along door walls of the one or more modular containers and an electric motor with a speed reduction gearbox and a shaft having a pinion at its end that is moved longitudinally into the steel rack to cause an opening of the side walls.

4. The portable data center of claim 1, option a), wherein the expandable and retractable ceiling and floor panels are supported on rubber wheels and extension bars, wherein the ceiling and floor panels roll on the rubber wheels and side guides and the extension bars sustain and push the floor and ceiling panels forward and backward, wherein preferably the extension bars are distributed uniformly along surfaces of the floor and ceiling panels, and/or wherein preferably the extension bars extend up to 180 degrees.

5. The portable data center of claim 1, wherein the extendable and retractable ceiling panels and floor panels comprise movable perimeter joints that have fire resistant and water tight gaskets to maintain fire resistance and water tightness of the one or more modular containers.

6. The portable data center of claim 1, option a), wherein the racks are mounted on a sliding rail guided system comprising rails, wherein the rails are composed of a lightweight material and ball bearing skates slide within the rail, wherein preferably the rails are mounted on top of an extended floor with height supports to extend its travel.

7. The portable data center of claim 1, option a) wherein the racks move independently of one another along an x-axis, and/or along a radial axis (twist movement).

8. The portable data center of claim 1, option a), further comprising an early detection fire system that analyzes smoke by a vacuum system through an inlet pipe distributed in the one or more modular containers, wherein the system processes air samples and identifies any smoke particle.

9. The portable data center of claim 1, option b) or claim 8 further comprising a monitoring system that monitors a plurality of condition parameters in an interior and exterior of the portable data center and generates an alarm when a threshold corresponding to a respective condition parameter is satisfied, wherein the condition parameters comprise temperature, humidity, water, fire, smoke, sound, pressure, air flow, electro-magnetic radiation, motion, and weight.

10. The portable data center of claim 1, option a), further comprising a water-based cooling system comprising one or more fan coils, wherein the fan coils are connected by a piping system to an external water chiller.

11. The portable data center of claim 1, option a), further comprising at least two modular containers that are configured in at least one of the following configurations: stacked vertically and further comprising at least one stair case connecting doors of the at least two modular containers for access to each modular container; and configured horizontally by juxtaposing the side walls of the at least two modular containers to create a single larger portable data center, whereby interior side walls of each of the at least two modular containers is removed during operation of the at least two modular containers.

12. The portable data center of claim 1, option a), further comprising a flexible cable management system that comprises a plurality of articulated parts in which at least one cable is passed through, wherein the plurality of articulated parts expand and retract back and forth, protecting the at least one cable which is passed through its interior, thereby mitigating damage to the cables due to movement of a rack, wherein preferably the flexible cable management system is integrated into at least one rack of the plurality of racks when the at least one rack is securely holding equipment having at least one cable attached thereto and extending therefrom and is plugged in or connected elsewhere.

13. The portable data center of claim 1, option a), wherein dimensions of the inner modular room are optimized for adaptation to dimensions of the one or more modular containers such that there is minimum space lost between walls, ceiling and floor of the inner modular room and the modular container.

14. The portable data center of claim 1, option a), wherein the modular container and the inner modular room are free of intermediate room columns for support.

15. The portable data center of claim 1, wherein the equipment secured in the plurality of racks comprises computing equipment, servers, machines, air conditioning systems, power supplies, and batteries.

16. The portable data center of claim 1, option a), further comprising one or more in-row cooling units that are positioned between one or more of the plurality of racks.

Fig. 1

Fig. 3

Fig. 2

Fig. 4A

Fig. 4B

EP 2 101 017 A2

Fig. 5A

Fig. 5B

Fig. 6

Fig. 7

Fig. 8A

Fig. 8B

**Fig. 9A**

**Fig. 9B**

**Fig. 9C**

1000

**Fig. 10**

**Fig. 11**

**Fig. 12**

**Fig. 13**

**Fig. 14**

**Fig. 15**

**Fig. 16**

**Fig. 17**

**Fig. 18**

**Fig. 19**

Fig. 20

**Fig. 21**

Fig. 22

Fig. 23

**REFERENCES CITED IN THE DESCRIPTION**

**Patent documents cited in the description**

•   US 61035516 A